(19) Europäisches Patentamt

European Patent Office

Office européen des brevets

(11) **EP 1 252 523 B1**

(12) **EUROPÄISCHE PATENTSCHRIFT**

(45) Veröffentlichungstag und Bekanntmachung des Hinweises auf die Patenterteilung:
**20.07.2005 Patentblatt 2005/29**

(21) Anmeldenummer: **01919119.6**

(22) Anmeldetag: **26.01.2001**

(51) Int Cl.⁷: **G01P 3/02**, G01P 3/12, B60R 21/01, H01H 35/00, H01H 35/14, H03M 1/78

(86) Internationale Anmeldenummer:
**PCT/DE2001/000311**

(87) Internationale Veröffentlichungsnummer:
**WO 2001/055729 (02.08.2001 Gazette 2001/31)**

(54) **SENSORANORDNUNG**

SENSOR ARRANGEMENT

DISPOSITIF CAPTEUR

(84) Benannte Vertragsstaaten:
**DE FR GB IT SE**

(30) Priorität: **29.01.2000 DE 10003992**

(43) Veröffentlichungstag der Anmeldung:
**30.10.2002 Patentblatt 2002/44**

(73) Patentinhaber: **ROBERT BOSCH GMBH 70442 Stuttgart (DE)**

(72) Erfinder: **STUETZLER, Frank-Jürgen Farmington Hills, MI 48331 (US)**

(56) Entgegenhaltungen:
EP-A- 0 775 613          DE-A- 2 212 190
DE-A- 4 007 726          US-A- 2 938 977
US-A- 3 525 262          US-A- 3 670 326
US-A- 3 717 735          US-A- 4 803 483
US-A- 4 995 639

• ROSS WALTER: "Electronically Controlled Resistor Bank" N.T.I.S TECH NOTES, ISSN 0889-8464 , Januar 1988 (1988-01), Seite 16 XP000128956

## Beschreibung

Stand der Technik

Die Erfindung betrifft eine Sensoranordnung, insbesondere zur Detektion mechanischer Kräfte, die beispielsweise bei einer Kollision eines Kraftfahrzeuges mit einem Hindernis zu einer Intrusion bzw. Deformation von Bauteilen an diesem Kraftfahrzeug führen.

Solche Sensoranordnungen werden beispielsweise bei sog. Rückhaltesystemen in Kraftfahrzeugen eingesetzt, die Unfällen z.B. Airbags auslösen um die Fahrzeuginsassen vor den Folgen einer Kollision zu schützen. Zur Auslösung dieser Rückhaltesysteme wird z.B. die Beschleunigung im Fahrgastinnenraum oder an peripheren Bereichen des Kraftfahrzeugs gemessen. Die peripheren Sensoren werden in der Regel zusätzlich zu dem oder den Sensoren im Fahrgastinnenraum, bevorzugt an den deformierbaren Bereichen des Fahrzeugs eingebaut. So sind z.B. für die bessere und frühzeitige Erkennung von seitlichen Kollisionen Beschleunigungssensoren auf der sog. B- und/oder C-Säule des Fahrzeugs oder auf den Sitzquerträgern unterhalb des Vordersitze eingebaut.

In vergleichbarer Weise werden auch zur besseren Erkennung von Frontalunfällen Sensoren in die vordere Knautschzone des Fahrzeugs eingebaut, die üblicherweise ebenfalls die Beschleunigung messen und die gemessenen Werte zur besseren Bestimmung der Schwere eines Unfalles in entsprechenden elektronisch auswertbare Signale umwandeln.

Insbesondere bei seitlichen Kollisionen haben die bekannten Beschleunigungssensoren den Nachteil, dass sie eine schnelle Unfallerkennung nur dann zulassen, wenn der Sensor direkt getroffen wird. So wird beispielsweise beim Einbau auf die B-Säule ein Pfahl-Aufprall in die Tür des Fahrzeugs zu spät erkannt. Auch für sich bekannte Drucksensoren bereiten bei einem Einbau an diesen Stellen Probleme hinsichtlich einer Trennung der Auslöse- und Nicht-Auslöse-Bedingungen, da sie z.B. bei heftigem Türzuschlagen nicht ansprechen sollen. Auch bei einer Auslösung von Fahrer- und Beifahrer Airbags dürfen diese Drucksensoren den Druckanstieg in Fahrgastinnenraum nicht als Deformation der Tür interpretieren.

Weiterhin ist bei einer Kollision die Geschwindigkeit des Eindringens des Hindernisses auch ein entscheidender Faktor, der die Schwere des Unfalls und die Verletzungsgefahr für die Insassen bestimmt. Die Eindringgeschwindigkeit ist dabei mit der Breite des Hindernisses und der Stelle des Auftreffens verknüpft. Beispielsweise dringt ein Pfahl mit einer kleinen Fläche sehr tief und schnell ein, während eine breite Barriere, die mit der gleichen Geschwindigkeit auf des Fahrzeug aufprallt, langsamer und nicht so tief eindringt. Wenn der Pfahl die Mitte der Tür trifft, so dringt er wesentlich schneller ein als wenn er auf die B-Säule trifft. Ein Hindernis wird dabei um so langsamer eindringen, je breiter es ist und es wird um so tiefer und schneller eindringen je weicher die Stelle des Auftreffens ist.

Aus DE-A-22 12 190 ist eine Sensoranordnung bekannt, bei der Deformationskräfte mit Hilfe von Kontaktelementen detektiert werden, welche in einer Verformungsrichtung hintereinander angeordnet sind. Daraus kann die Intrusionsgeschwindigkeit ermittelt werden. Ein Kontakt zwischen den Kontaktelementen erfolgt durch Verformung einer elastischen Zwischenschicht. Aus US-A-3,717,735 ist es bekannt, Verformungssensoren derart auszubilden, dass bei einer Verformung ein geschlossener Kontakt geöffnet wird. Aus US-A-2,938,977 ist eine Kontaktanordnung bekannt, die einseitig oder beidseitig in Teilbereichen mit einer Zwischenschicht versehen werden kann.

Vorteile der Erfindung

Eine eingangs erwähnte Sensoranordnung zur Detektion von Kräften, die zu einer Deformation von mechanischen Bauteilen, z.B. an Kraftfahrzeugen, führen, ist erfindungsgemäß in vorteilhafter Weise dadurch weitergebildet, dass nach dem Kennzeichen des Hauptanspruchs im wesentlichen an den ev. deformierten Bauteilen eine Anzahl Kontaktelemente vorhanden sind, die in einer möglichen Deformationsrichtung hintereinandergestaffelt angeordnet sind.

Zwischen den Kontaktelementen sind in vorteilhafter Weise durch die Deformation des Bauteils kompressierbare Isolationsschichten angeordnet. Die Kontaktelemente werden elektrisch leitend mit einer elektronischen Auswerteschaltung verbunden, mittels der dann ein durch die Deformation bewirktes Kontaktieren und/oder Entkontaktieren von benachbart angeordneten Kontaktelementen erfassbar und in Steuer- und/oder Regelsignale unwandelbar ist. Bei der erfindungsgemäßen Sensoranordnung ist es besonders vorteilhaft, wenn ein Kontaktelement ein Basiselement darstellt und mindestens zwei Kontaktelemente in jeweils vorgegebenen Abstanden davor angeordnet sind. Die Abstände, bzw, die geometrische Gestaltung und die Stoffauswahl dieser zwei kompressiblen Isolationsschichten sind dabei jeweils so gewählt, dass aus den Zeitpunkten des Kontaktierens und/oder Entkontaktierens der in Deformationsrichtung hintereinander liegenden Kontaktelemente die Intrusionsgeschwindigkeit des die Deformation verursachenden Gegenstandes herleitbar ist.

Die kompressible Isolationsschicht, z.B. aus Schaumstoff, zwischen den Kontaktelementen hat bei der Erfindung die Funktion einer korrekten Definition der geometrischen Abstände der Kontaktelemente. Das Kompressionsverhalten des Materials ist deshalb ebenso wie das Temperaturverhalten und die Steifigkeit unkritisch. Beim Aufbau der Sensoranordnung ist nur darauf zu achten, dass die Steifigkeiten über den Verlauf der Lebensdauer der Sensoranordnung nicht so hoch werden, dass ein Komprimieren der Sensoranordnung verhindert wird. In den meisten Anwendungsfällen sind die auftretenden Deformationskräfte so erheblich, dass ein auswertbares Deformieren allein dadurch schon gewährleistet ist, selbst wenn die Steifigkeit der Sensoranordnung variieren sollte.

Die Erfindung ermöglicht den Aufbau eines sog. Intrusionssensors für ein Kraftfahrzeug, der in einfacher Weise bei einem Unfall das Eindringens eines Hindernisses in die Bauteile des Fahrzeugs erkennt und dabei sowohl die Geschwindigkeit des Eindringens (Intrusionsgeschwindigkeit) als auch die Breite des aufprallenden Objekts und den Ort des Eindringens bestimmen lässt. Der Intrusionssensor selbst wird durch das Eindringen deformiert und die Deformation wird benutzt um die Kontaktelemente miteinander in Berührung zu bringen, wobei die Deformation selbst auch zur Bestimmung der Unfallschwere benutzt werden kann. Darüber hinaus kann der Intrusionssensor selbst dabei als konstruktives Element so genutzt werden, dass die Deformationscharakteristik des Fahrzeugs beeinflusst werden kann.

Ein solcher Intrusionssensor kann neben der seitlichen Plazierung auch zur Frontal- oder Heck-Aufprallerkennung eingesetzt werden. Er wird dann z.B. zwischen der Stoßstange und der Kunststoffverkleidung auf die Stoßstange montiert. In einer solchen Konfiguration misst der Sensor die Relativgeschwindigkeit des Aufpralls und es kann wiederum die Breite des Hindernisses und Ort des Auftreffens bestimmt werden. Mit diesem Intrusionssensor können dann beispielsweise auch Information über das aufprallende Hindernis erhalten werden.

Die Auswertung der mittels der Kontaktelemente erzeugten Signale erfolgt auf einfache Weise dadurch, dass die Kontaktelemente z. B. über eine Schutzbeschaltung, direkt an einen Mikroprozessor der elektronischen Auswerteschaltung angeschlossen werden, der die oben erwähnten Zeitpunkte, z.B. $T_1$ und $T_2$, direkt messen kann. Die Zeitpunkte $T_1$ und $T_2$ können jedoch auch durch Aufladung eines Kondensators bestimmt werden und als kodierte Information direkt an ein Auswertegerät, z.B. ein Airbag-Steuergerät in einem Kraftfahrzeug, geschickt werden.

Damit die Kontaktelemente sicher in Berührung kommen, muss die Sensoranordnung auch wirklich deformiert werden. Missbrauchsbedingungen, wie z.B. Hammerscbläge und ein Türschlagen werden den Sensor in der Regel nicht soweit deformieren, dass beide Kontaktelemente geschlossen werden. Die Missbrauchsprobleme, die bei den bekannten Beschleunigungs- oder Drucksensoren zum Teil sehr schwerwiegend sind, werden mit der Erfindung weitgehend verhindert. Wird beispielsweise der Sensor konstruktiv in der Nähe eines Verstärkungsrohres in der Tür eines Kraftfahrzeuges montiert, so wird die Sicherheit gegen Missbrauchsbedingungen nochmals erhöht.

Im folgenden werden vorteilhafte Anordnungen mit für besondere Anwendungsfälle ausgeführten Gestaltungen der Kontaktelemente und der Isolationsschichten sowie einer Schutzbeschaltung angegeben.

Bei diesen Anordnungen sind die kompressiblen Isolationsschichten in mindestens einem Teilbereich der Oberfläche der Kontaktelemente angeordnet und im jeweils verbleibende Bereich ist ein Kontakt mit dem benachbarten Kontaktelement durch Kompression der Isolationsschicht und/oder durch Verformung des jeweiligen Kontaktelements bewirkbar.

Bei einer ersten Anordnung sind die Isolationsschichten zwischen dem in Deformationsrichtung oben liegenden Kontaktelement und dem mittleren Kontaktelement in mindestens einem seitlichen Teilbereich angeordnet und die Isolationsschichten zwischen dem in Deformationsrichtung mittleren Kontaktelement und dem Basiselement sind in zwei gegenüberliegenden seitlichen Teilbereichen angeordnet.

Die Kontaktelemente sind hier geometrisch so ausgestattet, dass elektrischer Kontakt bei vollständiger Kompression der Isolationsschicht gewährleistet ist, wobei dies noch durch geeignete Stege auf dem Basiselement und ggf. auch auf den anderen Kontaktelementen unterstützt werden kann. Das Basiskontaktelement selbst kann auch geometrisch so geformt werden, dass es in der Mitte eine Erhöhung aufweist. Diese Erhöhung muss so hoch sein, dass sie etwa der Dicke des kompressiblen Materials in vollständig komprimierten Zustand entspricht.

Bei einer Ausführungsform der Erfindung ist die Isolationsschicht zwischen dem in Deformationsrichtung oben liegenden Kontaktelement und dem mittleren Kontaktelement in einem seitlichen Teilbereich angeordnet und die Isolationsschicht zwischen dem in Deformationsrichtung mittleren Kontaktelement und dem Basiselement ist im gleichen seitlichen Teilbereich angeordnet.

Hierbei befinden sich also die eigentlichen Kontaktflächen räumlich neben den kompressiblen Bereichen. Das Basiskontaktelement ist dabei so gestaltet, dass es stabil genug ist, damit erst das obere und das mittlere Kontaktelement und das kompressible Material zur Kontaktierung zusammengedrückt werden, bevor das Basiselement verbogen wird. Damit die Abfolge des Komprimierens definiert bleibt, ist es vorteilhaft, die Steifigkeit der ersten Isolationsschicht im Bereich zwischen dem oberen und dem mittleren Kontaktelement niedriger zu wählen als die der zweiten Isolationsschicht im Bereich zwischen dem mittlere Kontaktelement und dem Basiselement. Damit ist gewährleistet, dass zuerst das obere und das mittlere Kontaktelement geschlossen werden, bevor sich zum Zeitpunkt $T_2$ die zweite Isolationsschicht komprimiert.

Bei einer weiteren Anordnung bestehen mindestens zwei Kontaktelemente aus Teilkontaktelementen, die im Ruhezustand kontaktierend aneinander liegen. Die kompressiblen Isolationsschichten sind in mindestens einem Teilbereich der Oberfläche der mindestens zwei Kontaktelemente angeordnet und im jeweils verbleibende Bereich ist durch Kompression der Isolationsschicht und/oder durch Verformung des jeweiligen Kontaktelements ein Dekontaktieren bzw. Öffnen der Teilkontaktelemente bewirkbar.

Mit dieser Anordnung kann ein Intrusionssensor dadurch realisiert werden, dass durch das Eindringen eines Objekts und die resultierende Kompression das obere Kontaktelement, z.B. über einen elektrisch isolierenden Abstandhalter, auf einen ersten geschlossenen Kontakt des mittleren Kontaktelements gedrückt wird. Das obere Kontaktelement ist dabei geometrisch so geformt, dass der Kontakt des mittleren Kontaktelements geöffnet wird. Wird die Sensoranordnung weiter komprimiert, so drückt das mittlere Kontaktelement und ein elektrisch isolierender Abstandshalter auf ein unteres Kontaktelement am Basiselement und öffnen diese. Aus dem zeitlichen Abstand dieses Öffnens kann dann wiederum die Intrusionsgeschwindigkeit bestimmt werden.

Für eine besonders vorteilhafte Auswertung kann das obere Kontaktelement und das Basiskontaktelement aus einem magnetischen Material und das mittlere Kontaktelement eine Flachspule sein. Hierbei führt ein Kontaktieren der Kontaktelemente zu einer Änderung der Impedanz zwischen dem oberen und dem mittleren und zwischen dem mittleren und dem Basiskontaktelement. Das Schließen der Kontaktelemente kann dabei auch mittels einem oder mehreren Hallsensoren detektiert werden. Nach einer vorteilhaften Weiterbildung sind im oberen Kontaktelement und im Basiskontaktelement Permanentmagnete vorgesehen. Die Kontaktierung vom oberem und mittlerem Kontaktelement und/oder vom mittleren und vom Basiskontaktelement ist durch einen Kontakt der Hallsensoren mit den Permanentmagneten auf einfache Weise detektierbar.

Bei einer weiteren Ausführungsform können die Kontaktelemente durch zwei flächenartige Bruchkeramiken gebildet sein, die jeweils durch eine kompressible Isolationsschicht getrennt sind. Die Bruchkeramiken sind hier mit einer elektrisch leitfähigen Bahn oder Schicht versehen, deren Unterbrechung detektierbar ist. Eine Unterbrechung beim Eindringen eines Objektes definiert dabei den Zeitpunkt T des Auftreffens. Ein Bruch der oberen Keramik den Zeitpunkt $T_1$ des Auftreffens und der Bruch der unteren Keramik den Zeitpunkt $T_2$. Aus der Zeitdifferenz von $T_1$ und $T_2$ und der Dicke der kompressiblen Isolationsschicht kann dann die Intrusionsgeschwindigkeit bestimmt werden.

Es ist weiterhin vorteilhaft, wenn zumindest das obere und das mittlere Kontaktelement in einer Richtung, vorzugsweise der Längsrichtung, in mehrere Kontaktbereiche aufgeteilt ist, bei denen jeweils Paare von oberen und mittleren Kontaktelementen über jeweils separate Leitungen mit der Auswerteschaltung verbunden sind.

Durch diese Aufteilung kann auch eine Ortsinformation der Deformation gewonnen werden. Zwischen den jeweils zusammengehörigen Paaren kann nun auch für jeden Teilbereich der Sensoranordnung nahezu unabhängig die Intrusionsgeschwindigkeit und aus der Anzahl der komprimierten Unterteilungen kann die Breite des eindringenden Objekts bestimmt werden. Aus der Zeitabfolge des Schließens der jeweiligen Kontaktpaare kann darüber hinaus auch der Ort des primären Eindringens bestimmt werden.

Die Kontaktflächen der Kontaktelemente können an ihrer Oberfläche so behandelt sein, dass keine Korrosion stattfinden kann und das Schließen der Kontakte auch über die gesamte Lebensdauer der Sensoranordnung gewährleistet ist. Da die Sensoranordnung bei einer Anwendung im Kraftfahrzeug auch in die Tür oder auf der Stoßstange des Kraftfahrzeuges anbringbar ist, kann die Sensoranordnung auch auf einfache Weise mit einer wasserdichten Ummantelung umschlossen werden, die allerdings eine Deformation ungehindert zulassen muss. Diese Ummantelung kann beispielsweise ein dünner Gummimantel sein, der den Sensor hermetisch abschließt, eine Kompression und einen Druckausgleich bei Temperaturschwankungen aber zulässt. Die gesamte Sensoranordnung kann zum Beispiel auch in eine Ummantelung aus dünnem, leicht deformierbaren Metall, wie zum Beispiel einer dünnen Aluminium-Ummantelung eingebaut werden.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

Zeichnung

Ein Ausführungsbeispiel der erfindungsgemäßen Sensoranordnung wird anhand der Zeichnung erläutert. Es zeigen:

    Figur 1 eine schematische Darstellung, wobei die Sensoranordnung als Intrusionssensor in der Tür eines Kraftfahrzeuges angebracht ist;

    Figur 2 ein Ausführungsbeispiel mit einer Abwandlung der Anordnung von Kontaktelementen und Isolationsschichten im Intrusionssensor nach der Figur 1;

    Figur 3 eine Anordnung mit einer Abwandlung der Anordnung von Kontaktelementen und Isolationsschichten im Intrusionssensor nach der Figur 1,

Beschreibung des Ausführungsbeispies

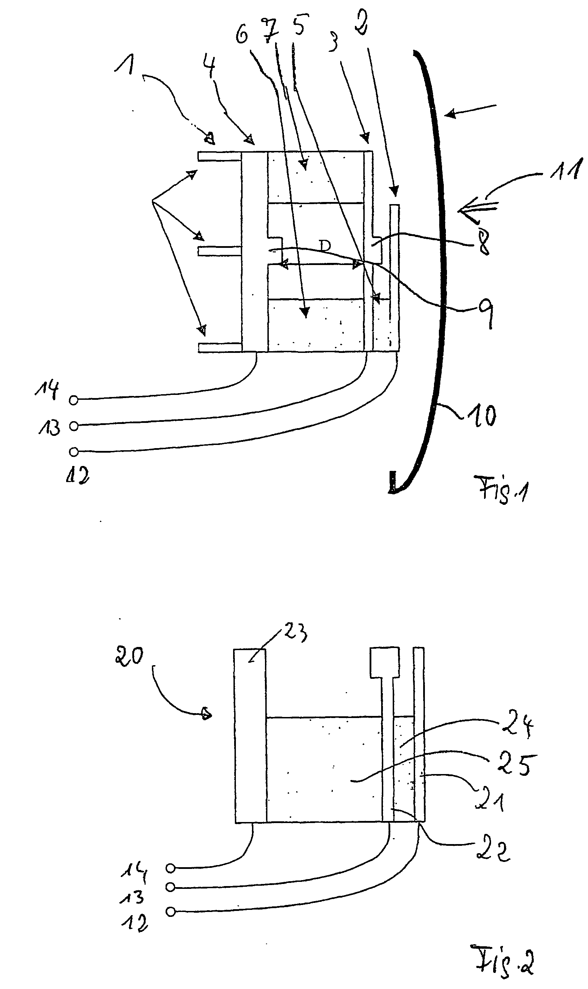

Eine Konfiguration einer Sensoranordnung 1 nach Figur 1 zeigt ein oberes elektrisch leitfähiges Kontaktelement 2, ein mittleres elektrisch leitfähiges Kontaktelement 3 und ein drittes elektrisch leitfähiges Kontaktelement 4 als Basiselement. Zwischen den Kontaktelementen 2, 3 und 4 liegen kompressible Isolationsschichten 5, 6 und 7, z.B. aus Schaumstoff, die die Kontaktelemente 2, 3 und 4 räumlich in einem vorgegebenen Abstand trennen, wobei hier insbesondere der Abstand D zwischen dem mittleren Kontaktelement 3 und dem Basiselement 4 für die Auswertung der Sensorsignale von Bedeutung ist.

Die Sensoranordnung 1 ist beispielsweise in die Türverkleidung 10 eines hier nicht näher dargestellten Kraftfahrzeuges eingebaut, die bei einem Unfall in einer Richtung 11 verformt werden kann. Die Kontaktelemente 2, 3 und 4 sind, ggf. mit Stegen 8 und 9, so ausgestattet, dass ein elektrischer Kontakt zwischen diesen Elementen 2, 3 und 4 bei vollständiger Kompression der Isolationsschichten 5, 6 und 7 aufgrund eines Unfalls gewährleistet ist.

Die Sensoranordnung 1 kann z.B. auf der Innenseite der Tür des Kraftfahrzeugs unterhalb der Verstärkungsrohre eingebaut werden, wobei die Sensoranordnung 1 die gesamte Länge_der Tür abdecken kann, beispielsweise vom vorderen Anschlag an die sog. A-Säule bis zum Türschloss. Wird die Türverkleidung 10 nun durch einen Aufprall eines Objekts eingedrückt, so wird das obere Kontaktelement 3 auf das mittlere Kontaktelement 4 gedrückt und damit kontaktiert, so dass über an diese Kontaktelemente 2, 3 und 4 angeschlossenen Leitungen 12, 13 und 14 der Zeitpunkt $T_1$ der Kontaktierung erfasst werden kann. Das Hindernis dringt dann weiter ein und drückt schließlich das oberes und das mittlere Kontaktelement 2 und 3 auf das Basiselement 4. Der Kontakt zwischen dem mittlerem Kontaktelement 3 und dem Basiselement 4 wird dann zu einem Zeitpunkt $T_2$ geschlossen.

Die Intrusionsgeschwindigkeit $V_i$ des Objekts kann dann aus dem bekannten Abstand D zwischen dem mittlerem Kontaktelement 3 und dem Basiselement 4 und den Zeitpunkten $T_1$ und $T_2$ nach der Beziehung

$$V_i = D / (T_2 - T_1) \qquad (1)$$

ermittelt werden. Typischerweise beträgt der Abstand D in etwa 2 cm, womit sich bei einer Geschwindigkeit von 20m/s (entspr. 72km/h) eine Zeitdifferenz $T_2 - T_1$ von 0.02/20 sec entsprechend 1 ms ergibt. Diese Zeitdifferenz ermöglicht sowohl eine direkte Messung durch einen Mikroprozessor in der Auswerteschaltung als auch ein schnelles Ansteuern von Aktuatoren im Fahrzeug, wie z.B. ein Airbag.

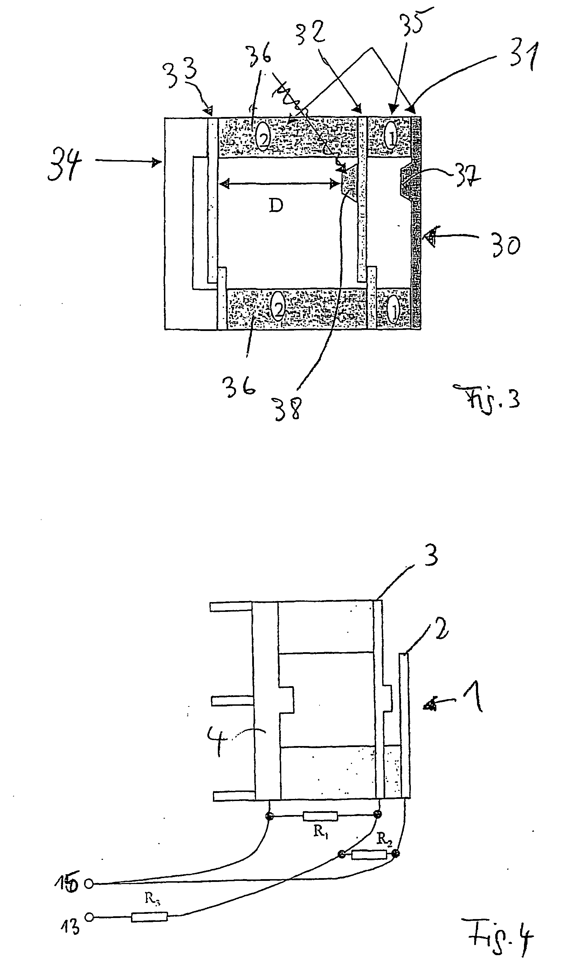

Bei einem Ausführungsbeispiel nach Figur 2 ist ein Intrusionssensor 20 mit Kontaktelementen 21, 22 und 23 versehen, die in Abwandlung zur Figur 1 einseitig mit jeweils einer Isolationsschicht 24 und 25 versehen sind. Die Ermittlung der Intrusionsgeschwindigkeit $V_i$ erfolgt hier in gleicher Weise wie beim Ausführungsbeispiel nach der Figur 1.

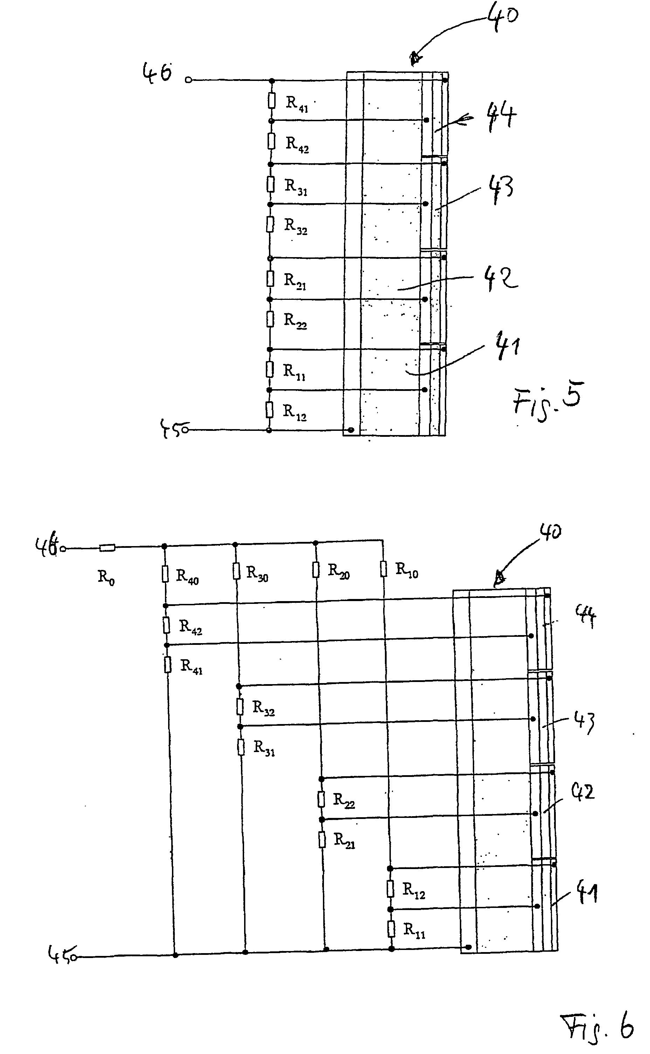

Aus Figur 3 ist eine Konfiguration einer Sensoranordnung zur Illustration 30 zu entnehmen, bei der ein oberes Kontaktelement als Druckplatte 31 ausgeführt ist. Es ist weiterhin eine mittleres Kontaktelement 32 und ein unteres Kontaktelement 33 an einer Basisplatte 34 vorhanden. Die Kontaktelemente 32 und 33 bestehen aus Teilkontaktelementen, die im Ruhezustand kontaktierend aneinander liegen. Kompressible Isolationsschichten 35 und 36 sind zwischen den Kontaktelementen 31 und 32 und zwischen 33 und 34 angebracht.

Durch Kompression der Isolationsschichten 35 und 36 bei einer Deformation des Sensorelements 30 öffnen dabei die Kontaktelemente 32 und 33. Beim Eindringen eines Objekts und die resultierende Kompression der Isolationsschichten 35 und 36 drückt die obere Druckplatte 31 auf einen ersten geschlossenen Kontakt der mittleren Kontaktplatte 32. Die Druckplatte 31 ist geometrisch so geformt, dass z.B. über eine elektrisch isolierende Erhebung 37 der Kontakt der mittleren Teilkontaktelemente 32 dabei geöffnet wird. Wird die Sensoranordnung weiter komprimiert, so drückt das mittlere Kontaktelement 32 und eine elektrisch isolierende Erhebung 38 auf das untere Kontaktelement 33 und öffnet hier den Kontakt. Aus dem zeitlichen Abstand des Öffnens kann wiederum, wie oben erwähnt, die Intrusionsgeschwindigkeit $V_i$ bestimmt werden.

Wie oben erwähnt, ist es sinnvoll, wenn die Kontaktelemente 2, 3, 4; 21, 22, 23 oder 31, 32, 33 über eine Schutzbeschaltung direkt an den Mikroprozessor der Auswerteschaltung angeschlossen werden können, der die Zeiten $T_1$ und $T_2$ direkt messen kann.

$$R = R_3 + R_2. \qquad (3).$$

**Patentansprüche**

1. Sensoranordnung zur Detektion von Kräften, die zu einer Deformation von mechanischen Bauteilen (10) führen, wobei

   - die Sensoranordnung (1;20;30;40) eine Anzahl Kontaktelemente (2,3,4;21,22,23;31,32,33) aufweist, die in einer möglichen Deformationsrichtung (11) hintereinandergestaffelt am Bauteil (10) angeordnet sind, wobei zwischen den Kontaktelementen (2,3,4;21,22,23;31,32, 33) kompressible Isolationsschichten (5,6,7;24,25; 35, 36) liegen, wobei

   - die Kontaktelemente (2,3,4;21,22,23; 31,32,33) elektrisch leitend mit einer elektronischen Auswerteschaltung verbunden sind, mittels der ein durch eine Deformation bewirktes Kontaktieren und/oder Entkontaktieren von benachbart angeordneten Kontaktelementen (2,3,4; 21,22,23;31,32,33) erfassbar und in Steuer- und/oder Regelsignale unwandelbar ist,

- wobei ein Kontaktelement ein Basiselement (4; 23;33,34) darstellt und mindestens zwei Kontaktelemente (4;21,22;31,32) in jeweils vorgegebenen Abständen (D) dazu angeordnet sind, wobei die Abstände (D) oder die mindestens zwei kompressiblen Isolationsschichten (5,6,7; 24,25;35,36) jeweils so ausgestaltet sind, dass aus den Zeitpunkten($T_1,T_2$) des Kontaktierens und/oder Entkontaktierens der in Deformationsrichtung hintereinander liegenden Kontaktelemente (2,3,4;21,22,23; 31,32,33) die Intrusionsgeschwindigkeit ($V_i$) des die Deformation verursachenden Gegenstandes herleitbar ist, **dadurch gekennzeichnet, dass** eine erste Isolationsschicht im Bereich zwischen einem oberen und einem mittleren Kontaktelement eine niedrigere Steifigkeit aufweist als eine zweite Isolationsschicht im Bereich zwischen dem mittleren Kontaktelement und dem Basiselement, **dass**

- die Isolationsschicht (24) zwischen dem in Deformationsrichtung oben liegenden Kontaktelement (21) und dem mittleren Kontaktelement (22) in einem seitlichen Teilbereich angeordnet ist und dass

- die Isolationsschicht (25) zwischen dem in Deformationsrichtung mittleren Kontaktelement (22) und dem Basiselement (23) im gleichen seitlichen Teilbereich angeordnet ist.

2. Sensoranordnung nach Anspruch 1 oder 2, **dadurch gekennzeichnet, dass**

- die kompressiblen Isolationsschichten (5,6,7; 24,25; 35,36) in mindestens einem Teilbereich der Oberfläche der Kontaktelemente (2,3,4; 21,22,23;31,32,33) angeordnet sind und dass
- im jeweils verbleibende Bereich ein Kontakt mit dem benachbarten Kontaktelement (2,3,4; 21,22,23;31,32,33) durch Kompression der Isolationsschicht (5,6,7;24,25;35,36) und/oder durch Verformung des jeweiligen Kontaktelements bewirkbar ist.

3. Sensoranordnung nach einem der vorhergehenden Ansprüche, **dadurch gekennzeichnet, dass**

- die kompressiblen Isolationsschichten (5,6,7;

24,25; 35,36) aus Sehaumstoff sind.

4. Sensoranordnung nach einem der vorhergehenden Ansprüche, **dadurch gekennzeichnet, dass**

- die Kontaktelemente (2,3,4;21,22,23; 31,32,33) mit einer Korrosionsschutzschicht und die Sensoranordnung (1;20,30,40) mit einem feuchtigkeitsdichten Schutzfilm, vorzugsweise aus gummielastischen Material, überzogen sind.

5. Sensoranordnung nach einem der Ansprüche 1 bis 4, **dadurch gekennzeichnet, dass**

- die gesamte Sensoranordnung (1;20,30,40) von einer hermetisch verschlossenen Metallummantelung aus dünnem, weichem, leicht kompressiblen Metall umschlossen ist und eine feuchtigkeitsdichte elektrische Verbindung nach außen aufweist.

**Claims**

1. Sensor arrangement for detecting forces which lead to a deformation of mechanical components (10), wherein

- the sensor arrangement (1; 20; 30; 40) has a number of contact elements (2, 3, 4; 21, 22, 23; 31, 32, 33) which are arranged stacked one behind the other on the component (10) in a possible deformation direction (11), wherein compressible insulating layers (5, 6, 7; 24, 25; 35, 36) are located between the contact elements (2, 3, 4; 21, 22, 23; 31, 32, 33), wherein
- the contact elements (2, 3, 4; 21, 22, 23; 31, 32, 33) are electrically conductively connected to an electronic evaluation circuit, by means of which formation of contact and/or elimination of contact between adjacently arranged contact elements (2, 3, 4; 21, 22, 23; 31, 32, 33) which is brought about by deformation can be sensed and converted into control and/or regulation circuits,
- wherein a contact element constitutes a basic element (4; 23; 33, 34) and at least two contact elements (4; 21, 22; 31, 32) are arranged at respectively predefined distances (D) therefrom, wherein the distances (D) or the at least two compressible insulating layers (5, 6, 7; 24, 25; 35, 36) are each configured in such a way that the intrusion velocity ($V_i$) of the object causing the deformation can be derived from the times ($T_1$, $T_2$) of the formation of contact and/or elimination of contact between the contact elements (2, 3, 4; 21, 22, 23; 31, 32, 33) which lie one behind the other in the deformation direction, **characterized in that** a first insulating layer in the region between an upper contact element and a middle contact element has a lower degree of stiffness than a second insulating layer in the region between the middle contact element and the basic element, **in that**

- the insulating layer (24) is arranged between the contact element (21) which lies at the top in the deformation direction and the middle contact element (22) in a lateral partial region, and **in that**
- the insulating layer (25) is arranged between the contact element (22) which is in the middle in the deformation direction and the basic element (23) in the same lateral partial region.

**2.** Sensor arrangement according to Claim 1 or 2, **characterized in that**

- the compressible insulating layers (5, 6, 7; 24, 25; 35, 36) are arranged in at least one partial region of the surface of the contact elements (2, 3, 4; 21, 22, 23; 31, 32, 33), and **in that**
- a contact with the adjacent contact element (2, 3, 4; 21, 22, 23; 31, 32, 33) can be brought about in the respectively remaining region by compression of the insulating layer (5, 6, 7; 24, 25; 35, 36) and/or by deformation of the respective contact element.

**3.** Sensor arrangement according to one of the preceding claims, **characterized in that**

- the compressible insulating layers (5, 6, 7; 24, 25; 35, 36) are made of foamed material.

**4.** Sensor arrangement according to one of the preceding claims, **characterized in that**

- the contact elements (2, 3, 4; 21, 22, 23; 31, 32, 33) are coated with a corrosion protection layer, and the sensor arrangement (1; 20, 30, 40) is coated with a moisture-proof protective film, preferably made of rubber-elastic material.

**5.** Sensor arrangement according to one of Claims 1 to 4, **characterized in that**

- the entire sensor arrangement (1; 20, 30, 40) is surrounded by a hermetically sealed metal enclosure made of thin, soft, easily compressible metal and has a moisture-proof electrical connection to the outside.

**Revendications**

**1.** Système de capteurs pour détecter des forces qui provoquent une déformation sur des pièces mécaniques (10),
dans lequel

- le système de capteurs (1 ; 20 ; 30 ; 40) présente un certain nombre d'éléments de contact (2, 3, 4 ; 21, 22, 23 ; 31, 32, 33) échelonnés les uns derrière les autres sur le composant (10) dans une direction de déformation (11) possible, des couches isolantes (5, 6, 7 ; 24, 25 ; 35, 36) compressibles se trouvant entre les éléments de contact (2, 3, 4 ; 21, 22, 23 ; 31, 32, 33).
- les éléments de contact (2, 3, 4 ; 21, 22, 23 ; 31, 32, 33) sont reliés de façon électroconductrice à un circuit électronique d'exploitation à l'aide duquel il est possible de détecter que des éléments de contact (2, 3, 4 ; 21, 22, 23 ; 31, 32, 33) contigus sont mis en contact et/ou ne sont plus en contact du fait d'une déformation et de le convertir en signaux de commande et/ou de réglage,
- un élément de contact représente un élément de base (4 ; 23 ; 33, 34) et au moins deux éléments de contact (4 ; 21, 22 ; 31, 32) sont placés par rapport à eux à des distances (D) à chaque fois prédéfinies, les distances (D) ou les au moins deux couches isolantes (5, 6, 7 ; 24, 25 ; 35, 36) compressibles étant chacune conçues de telle manière que la vitesse d'intrusion ($V_i$) de l'objet à l'origine de la déformation peut être déduite des instants ($T_1$, $T_2$) où les éléments de contact (2, 3, 4 ; 21, 22, 23 ; 31, 32, 33) placés les uns derrière les autres sont mis en contact et/ou ne sont plus en contact en direction de déformation,

**caractérisé en ce que**

- dans la zone entre un élément supérieur de contact et un élément médian de contact, une première couche isolante a une rigidité plus faible qu'une deuxième couche isolante dans la zone entre l'élément médian de contact et l'élément de base,
- la couche isolante (24) entre l'élément de contact (21) du haut en direction de déformation et l'élément médian de contact (22) est placée dans une zone partielle latérale, et
- la couche isolante (25) entre l'élément médian de contact (22) en direction de déformation et l'élément de base (23) est placée dans la même zone partielle latérale.

**2.** Système de capteurs selon la revendication 1 ou 2,

**caractérisé en ce que**

- les couches isolantes (5, 6, 7 ; 24, 25 ; 35, 36) compressibles sont placées dans au moins une zone partielle de la surface des éléments de contact (2, 3, 4 ; 21, 22, 23 ; 31, 32, 33), et
- dans chaque zone subsistante un contact peut être établi avec l'élément de contact (2, 3, 4 ; 21, 22, 23 ; 31, 32, 33) contigu en comprimant la couche isolante (5, 6, 7 ; 24, 25 ; 35, 36) et/ ou en déformant l'élément de contact en question.

3. Système de capteurs selon l'une des revendications précédentes,
   **caractérisé en ce que**

- les couches isolantes (5, 6, 7 ; 24, 25 ; 35, 36) compressibles sont en mousse synthétique.

4. Système de capteurs selon l'une des revendications précédentes,
   **caractérisé en ce que**

- les éléments de contact (2, 3, 4 ; 21, 22, 23 ; 31, 32, 33) sont revêtus d'une couche anticorrosion et le système de capteurs (1 ; 20, 30, 40) est revêtu d'un film protecteur étanche à l'humidité, de préférence en matériau élastique.

5. Système de capteurs selon l'une des revendications 1 à 4,
   **caractérisé en ce que**

- tout le système de capteurs (1 ; 20, 30, 40) est entouré par une enveloppe métallique hermétiquement fermée constituée d'un métal mince, mou et facile à comprimer et présente une liaison électrique vers l'extérieur étanche à l'humidité.

6 7 5 3 2

1  4

11

8

9

D

14

13

12

10

Fig.1

20

23

24

25

21

22

14

13

12

Fig.2

Fig. 3

Fig. 4

Fig. 5

Fig. 6